# EUROPEAN PATENT APPLICATION

(11) **EP 4 350 746 A1**
(43) Date of publication of application: **10.04.2024**
(21) Application number: 21943040.2
(22) Date of filing: 27.05.2021
(51) Int. Cl.: H01L 21/338, H01L 29/812

(54) **SEMICONDUCTOR DEVICE**

(71) Applicant: Nippon Telegraph And Telephone Corporation, Chiyoda-ku Tokyo 100-8116 (JP)
(72) Inventor: TSUTSUMI, Takuya, Musashino-shi, Tokyo 180-8585 (JP); MATSUZAKI, Hideaki, Musashino-shi, Tokyo 180-8585 (JP); SUGIYAMA, Hiroki, Musashino-shi, Tokyo 180-8585 (JP)
(74) Representative: Samson & Partner Patentanwälte mbB
(86) International application number: PCT/JP2021/020172
(87) International publication number: WO 2022/249391

(57) **Abstract**

A field-effect transistor (100a) includes a channel layer (102) made of a compound semiconductor and formed on a substrate (101); a gate electrode (103) formed on the channel layer (102); and a source electrode (104) and a drain electrode (105), which are formed with the gate electrode (103) interposed therebetween. At least one of the source electrode (104) and the drain electrode (105) is formed on a substrate (101) side of the channel layer (102).

## Description

### [Technical Field]

The present invention relates to a semiconductor device.

### [Background Art]

Electronic devices and integrated circuits, capable of handling a terahertz frequency band of 0.3 to 3.0 THz, have been drawing attention as elemental technology for high-speed wireless communication using millimeter waves, non-destructive internal inspection using 3D imaging, and component analysis using electromagnetic wave absorption. Generally, field-effect transistors made of compound semiconductors with particularly high electron mobility in terms of physical properties are used as electronic devices with good high-frequency characteristics.

A field-effect transistor includes a semiconductor substrate, a gate electrode formed on a surface of the semiconductor substrate, and a source electrode and a drain electrode which are formed on both sides of the gate electrode in ohmic contact. Especially a high-electron mobility transistor (HEMT) with excellent high-frequency characteristics has a configuration where, for example, a buffer layer, a channel layer, a barrier layer and a cap layer are laminated on a semiconductor substrate in this order from a side of the substrate. Further, a carrier supply layer is formed on a barrier layer side with respect to the channel layer, or alternatively, a buffer layer side with respect the channel layer. In such a configuration, a position and doping amount of the carrier supply layer are determined in response to energy band design.

When applying a potential to the gate electrode, carriers are supplied from the carrier supply layer to the channel layer in accordance with the intensity of the applied potential, and therefore a concentration of a two-dimensional electron gas is modulated, whereby electrons move through a conduction channel formed between the source and drain electrodes. In the HEMT structure, a channel layer through which carriers travel and an electron supply layer are spatially separated to suppress scattering due to impurities. With this configuration, electron mobility can be improved, and thus terahertz operation can be implemented.

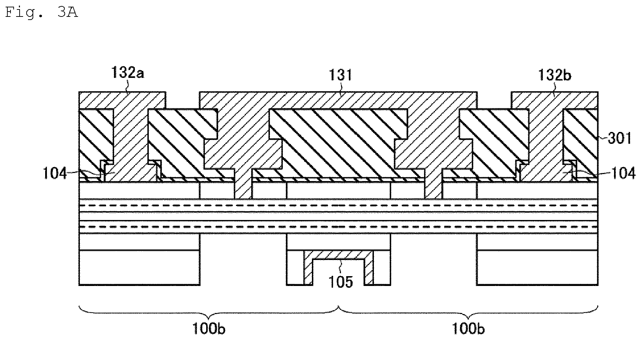

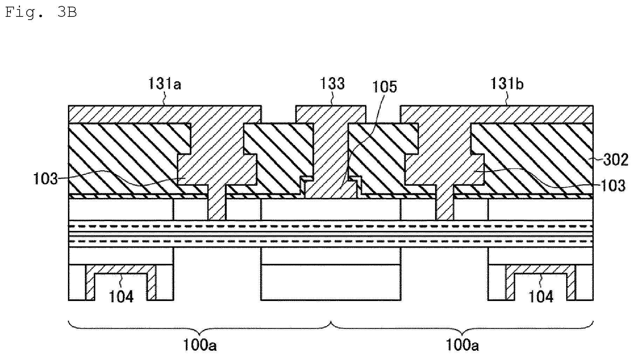

For example, NPL 1 discloses HEMT fabrication in which a resist pattern is formed and used as a mask to etch a gate insulation film to form an opening; the resist is removed, and then the formed opening serves as a mask in recess etching of a cap layer using a recess stopper layer; and dry etching is performed to etch in a depth direction a recess stopper layer, or a barrier layer in addition to the recess stopper layer using argon gas, after which a gate electrode is formed, thereby forming a field-effect transistor structure with a reduced gate-channel distance (Fig. 3).

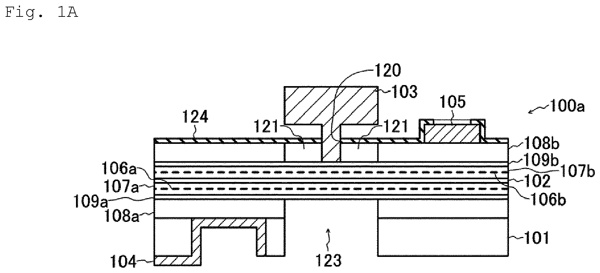

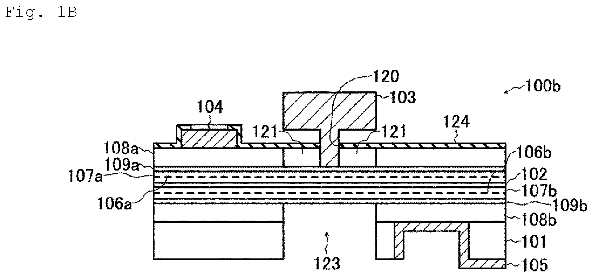

PTL 1 discloses that an extra recess opening is formed on a drain side of an insulation film such that a drain-side recess region is wider than a source-side recess region, and recess-forming etchant is infiltrated into both a gate opening and a recess opening, thereby forming an asymmetrical recess structure. Drain conductance is reduced and high-frequency characteristics are improved by depleting carries over a wider region on the drain electrode side (Figs. 1 and 4 of PTL 1).

### [Citation List]

### [Patent Literature]

[PTL 1] Japanese Patent No. 3715557

### [Non Patent Literature]

[NPL 1] T. Suemitsu et al., "Improved Recessed-Gate Structure for Sub-0.1-um-Gate InP-Based High Electron Mobility Transistors", Japanese Journal of Applied Physics, vol. 37, No. 1363-1372, 1998.

### [Summary of Invention]

### [Technical Problem]

For introducing transistors such as HEMTs into terahertz integrated circuits, it is necessary to enhance their high-frequency characteristics; therefore, it is required to minimize the parasitic capacitance between the gate electrode and the source and gate electrodes as much as possible. In order to further increase the frequency of transistors, it is important to further reduce a distance between the gate electrode and the source and drain electrodes in addition to miniaturization of the gate electrode. However, the conventional technology stated above has drawbacks that the external parasitic capacitance mainly increases as the distance between the gate electrode and the source and drain electrodes is reduced, because the gate electrode and the source and drain electrodes are formed on the same surface, which becomes a factor disturbing the speed-up of transistors.

The present invention is intended to solve the problems stated above and an object of the present invention is to further reduce the distance between the gate electrode and the source and drain electrodes to speed up transistors.

### [Solution to Problem]

A semiconductor device according to the present invention is provided with a field-effect transistor, which includes a channel layer made of a compound semiconductor and formed on a substrate; a gate electrode formed on the channel layer; and a source electrode and a drain electrode, both formed with the gate electrode interposed therebetween, wherein at least one of the source electrode and the drain electrode is formed on a side of the substrate of the channel layer.

### [Advantageous Effects of Invention]

As described above, according to the present invention, at least one of the source electrode and the drain electrode is formed on the side of the substrate of the channel layer, and thus the distance between the gate electrode and the source and drain electrodes is further reduced to speed up the transistor.

### [Brief Description of Drawings]

[Fig. 1A]
   Fig. 1A is a cross-sectional view illustrating a configuration of a semiconductor device according to a first embodiment of the present invention.
[Fig. 1B]
   Fig. 1B is a cross-sectional view illustrating a configuration of the other semiconductor device according to the first embodiment of the present invention.
[Fig. 2]

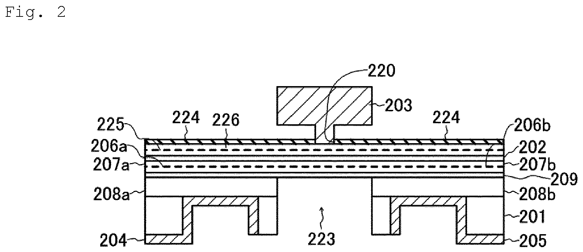

   Fig. 2 is a cross-sectional view illustrating a configuration of a semiconductor device according to a second embodiment of the present invention.
[Fig. 3A]
   Fig. 3A is a cross-sectional view illustrating a configuration of a semiconductor device according to a third embodiment of the present invention.
[Fig. 3B]
   Fig. 3B is a cross-sectional view illustrating a configuration of the other semiconductor device according to the third embodiment of the present invention.

### [Description of Embodiments]

The semiconductor device according to the embodiment of the present invention will be described hereinbelow.

### [First Embodiment]

A semiconductor device according to a first embodiment of the present invention will be described with reference to Figs. 1A and 1B. This semiconductor device is a field-effect transistor 100a including a channel layer 102 made of a compound semiconductor and formed on a substrate 101; a gate electrode 103 formed on the channel layer 102; and a source electrode 104 and a drain electrode 105, which are formed with the gate electrode 103 interposed therebetween.

At least one of the source electrode 104 and the drain electrode 105 is formed on the channel layer 102 on a side of the substrate 101 in this semiconductor device. The field-effect transistor 100a has the source electrode 104 formed on the channel layer 102 on the side of the substrate 101. As illustrated in Fig. 1B, the field-effect transistor 100b with the drain electrode 105 formed on the channel layer 102 on the side of the substrate 101 is also allowable.

This semiconductor device is further provided with a first carrier supply layer 106a formed between the source electrode 104 and the channel layer 102, and a first barrier layer 107a made of a compound semiconductor and formed between the source electrode 104 and the channel layer 102. Moreover, this semiconductor device is further provided with a second carrier supply layer 106b formed between the drain electrode 105 and the channel layer 102, and a second barrier layer 107b made of a compound semiconductor and formed between the drain electrode 105 and the channel layer 102.

In the field-effect transistor 100a as shown in Fig. 1A, the source electrode 104, the first carrier supply layer 106a, and the first barrier layer 107a are formed on the channel layer 102 on the side of the substrate 101.

Further, in the field-effect transistor 100b as shown in Fig. 1B, the drain electrode 105, the second carrier supply layer 106b, and the second barrier layer 107b are formed on the channel layer 102 on the side of the substrate 101.

In either case, the semiconductor device according to the first embodiment may have the first carrier supply layer 106a and the first barrier layer 107a which are formed in a region where at least the source electrode 104 is formed with the gate electrode 103 interposed therebetween in a gate length direction. The semiconductor device may also have the second carrier supply layer 106b and the second barrier layer 107b which are formed in a region where at least the drain electrode 105 is formed with the gate electrode 103 interposed therebetween in the gate length direction.

This semiconductor device may also include a first contact layer 108a made of a compound semiconductor and formed between the source electrode 104 and the first barrier layer 107a, and a second contact layer 108b made of a compound semiconductor and formed between the drain electrode 105 and the second barrier layer 107b. The source electrode 104 is formed in ohmic contact with the first contact layer 108a, and the drain electrode 105 is formed in ohmic contact with the second contact layer 108b.

In this example, both the field-effect transistor 100a and the field-effect transistor 100b have a well-known recessed gate structure, and have a recess region 121 at a place where the gate electrode 103 is formed. A groove 123 is formed on a side of the substrate of the region where the gate electrode 103 is formed. The field-effect transistor used as the semiconductor device according to the first embodiment is not limited to the field-effect transistor with the recessed gate structure, and may be a field-effect transistor having another structure such as MIS.

In the field-effect transistor 100a, the recess region 121 separates the second contact layer 108b into a side of the source electrode 104 and a side of the drain electrode 105. Further, the substrate 101 and the first contact layer 108a are separated by the groove 123 into sides of the source electrode 104 and sides of the drain electrode 105.

In the field-effect transistor 100b, the recess region 121 separates the first contact layer 108a into a side of the source electrode 104 and a side of the drain electrode 105. Further, the substrate 101 and the second contact layer 108b are separated by the groove 123 into sides of the source electrode 104 and sides of the drain electrode 105.

The semiconductor device may also include a first etching stop layer 109a formed between the first contact layer 108a and the first barrier layer 107a. The semiconductor device may also include a second etching stop layer 109b formed between the second contact layer 108b and the second barrier layer 107b. Each of the etching stop layers may be made of a material having high etching selectivity with respect to an etchant used for etching to form the recess region 121 and the groove 123.

The semiconductor device may also include an insulation layer 124 formed on the first contact layer 108a. The insulation layer 124 has an opening 120. In the field-effect transistor 100a, the insulation layer 124 is formed also on the drain electrode 105 and is provided with the opening on a part of an upper surface of the drain electrode 105. In the field-effect transistor 100b, the insulation layer 124 is formed also on the source electrode 104 and is provided with the opening on a part of an upper surface of the source electrode 104.

For example, the substrate 101 may be composed of semiinsulating InP. The channel layer 102 may be made of InGaAs and have a thickness of 5 to 20 nm. Alternatively, the channel layer 102 may have a composite structure of InGaAs layers and InAs layers.

The first barrier layer 107a and the second barrier layer 107b each may be made of InAIAs and have a thickness of 5 to 20 nm. The first carrier supply layer 106a and the second carrier supply layer 106b may be respectively formed on the first barrier layer 107a and the second barrier layer 107b, as layers doped with Si at 1×10¹⁹ cm⁻³ to 3×10¹⁹ cm⁻³ as impurities by means of well-known sheet doping.

The first contact layer 108a and the second contact layer 108b may be made of InGaAs doped with Si at 1×10¹⁹ cm⁻³ to 2×10¹⁹ cm⁻³, for example. The first etching stop layer 109a and the second etching stop layer 109b each may be made of InP and have a thickness of 2 to 5 nm.

The layer of the compound semiconductor described above may be formed by crystal growth using, for example, metal-organic chemical vapor deposition or molecular beam epitaxy.

The gate electrode 103 is formed on the insulation layer 124 and partially inserted into the recess region 121 via the opening 120. The gate electrode 103 is formed in a depth direction from the opening 120 to the first etching stop layer 109a or the second etching stop layer 109b. A recess length may be approximately 20 to 200 nm.

A center position of the groove 123 in the gate length direction is basically aligned with the center of the recess region 121. It is not necessary to strictly match these positions. Further, a length of the groove 123 in the gate length direction may be approximately 20 to 200 nm, however considering the difficulty in miniaturization for rear side processing, it may be set to approximately 10 to 20 um. Alternatively, the groove 123 may be filled with, for example, an insulating resin or an insulation compound semiconductor formed by crystal regrowth.

The gate electrode 103 may be formed mainly from a composite structure of Ti, Pt, Au and Mo. In order to achieve a short gate length while reducing the gate resistance as much as possible, the gate electrode 103 may be T-shaped, Y-shaped, or Γ-shaped in which an upper portion has a wider area than a lower portion in plan view. A gate insulation layer may also be formed on the etching stop layer.

The source electrode 104 and the drain electrode 105 each may be composed of, for example, a laminated structure of metals such as Ti, Pt, Au, and Ni. The insulation layer 124 may be composed of an oxide such as SiO₂, SiN, Al₂O₃, HfO₂ or TiO₂, a nitride film, or a composite film of these. A thickness of the insulation layer 124 may fall within a range of approximately 10 to 100 nm depending on the gate length.

According to the first embodiment described above, for example, the field-effect transistor 100a has the source electrode 104 arranged on a rear side of the substrate 101. Therefore, even if the distance between the source and the drain is set to be shorter, a sufficient distance between the source electrode 104 and the gate electrode 103 is ensured, thus the parasitic capacitance generated between the gate electrode 103 and the source electrode 104 is reduced, thereby improving high-frequency characteristics.

Similarly, the field-effect transistor 100b has the drain electrode 105 arranged on a rear side of the substrate 101. Therefore, even if the distance between the source and the drain is set to be shorter, a sufficient distance between the drain electrode 105 and the gate electrode 103 is ensured, thus the parasitic capacitance generated between the gate electrode 103 and the drain electrode 105 is reduced, thereby improving high-frequency characteristics.

### [Second Embodiment]

The semiconductor device according to a second embodiment of the present invention will be described with reference to Fig. 2. This semiconductor device is a field-effect transistor including a channel layer 202 made of a compound semiconductor and formed on a substrate 201; a gate electrode 203 formed on the channel layer 202; and a source electrode 204 and a drain electrode 205, which are formed with the gate electrode 203 interposed therebetween.

Both the source electrode 204 and the drain electrode 205 are formed on the channel layer 202 on a side of the substrate 201 in the semiconductor device according to the second embodiment.

This semiconductor device is further provided with a first carrier supply layer 206a formed between the source electrode 204 and the channel layer 202, and a first barrier layer 207a made of a compound semiconductor and formed between the source electrode 204 and the channel layer 202. Moreover, this semiconductor device is further provided with a second carrier supply layer 206b formed between the drain electrode 205 and the channel layer 202, and a second barrier layer 207b made of a compound semiconductor and formed between the drain electrode 205 and the channel layer 202.

In the semiconductor device according to the second embodiment, the first carrier supply layer 206a, the first barrier layer 207a, the second carrier supply layer 206b, and the second barrier layer 207b are formed on the channel layer 102 on the side of the substrate 101. The first carrier supply layer 206a and the second carrier supply layer 206b are integrally formed, and the first barrier layer 207a and the second barrier layer 207b are integrally formed.

This semiconductor device may also include a first contact layer 208a made of a compound semiconductor and formed between the source electrode 204 and the first barrier layer 207a, and a second contact layer 208b made of a compound semiconductor and formed between the drain electrode 205 and the second barrier layer 207b. The source electrode 204 is formed in ohmic contact with the first contact layer 208a, and the drain electrode 205 is formed in ohmic contact with the second contact layer 208b.

This field effect transistor has a groove 223 on a side of the substrate of a region where the gate electrode 203 is formed. The groove 223 separates the first contact layer 208a and the second contact layer 208b from each other.

The semiconductor device may also include an etching stop layer 209 formed between the first contact layer 208a and the first barrier layer 207a. In this semiconductor device, the etching stop layer 209 is also formed between the second contact layer 208b and the second barrier layer 207b. The etching stop layer 209 may be made of a material having high etching selectivity with respect to an etchant used for etching to form the groove 223.

The semiconductor device may further include a third carrier supply layer 225 formed between the channel layer 202 and the gate electrode 203, and a third barrier layer 226 made of a compound semiconductor. The semiconductor device may also include an insulation layer 224 formed on the first contact layer 208a. The insulation layer 224 has an opening 220.

For example, the substrate 201 may be composed of semiinsulating InP. The channel layer 202 may be made of InGaAs and have a thickness of 5 to 20 nm. Alternatively, the channel layer 202 may have a composite structure of InGaAs layers and InAs layers.

The first barrier layer 207a and the second barrier layer 207b, which are integrally formed, may be made of InAIAs and have a thickness of 5 to 20 nm. The first carrier supply layer 206a and the second carrier supply layer 206b, which are integrally formed, may be formed on the first barrier layer 207a and the second barrier layer 207b, as a layer doped with Si at 1×10¹⁹ cm⁻³ to 3×10¹⁹ cm⁻³ as impurities by means of well-known sheet doping.

The first contact layer 208a and the second contact layer 208b may be made of InGaAs doped with Si at 1×10¹⁹ cm⁻³ to 2×10¹⁹ cm⁻³, for example. The etching stop layer 209 may be made of InP and have a thickness of 2 to 5 nm.

The third barrier layer 226 may be made of InAIAs and have a thickness of 5 to 20 nm. The third carrier supply layer 225, which is doped with Si at 1×10¹⁹ cm⁻³ as impurities, may be formed on the third barrier layer 226 by means of well-known sheet doping.

The layer of the compound semiconductor described above may be formed by crystal growth using, for example, metal-organic chemical vapor deposition or molecular beam epitaxy.

The gate electrode 203 is formed on the insulation layer 224, partially inserted through the opening 220, and connected to the third barrier layer 226, for example, in Schottky contact. The center position of the groove 223 in the gate length direction is basically aligned with the center of the gate electrode 203 in the gate length direction. It is not necessary to strictly match these positions. Further, a length of the groove 223 in the gate length direction may be approximately 20 to 200 nm, however considering the difficulty in miniaturization for rear side processing, it may be set to approximately 10 to 20 um. Alternatively, the groove 223 may be filled with, for example, an insulating resin or an insulation compound semiconductor formed by crystal regrowth.

The gate electrode 203 may be formed mainly from a composite structure of Ti, Pt, Au and Mo. In order to achieve a short gate length while reducing the gate resistance as much as possible, the gate electrode 203 may be T-shaped, Y-shaped, or Γ-shaped in which an upper portion has a wider area than a lower portion in plan view. A gate insulation layer may also be formed on the etching stop layer.

The source electrode 204 and the drain electrode 205 each may be composed of, for example, a laminated structure of metals such as Ti, Pt, Au, and Ni. The insulation layer 224 may be composed of an oxide such as SiO₂, SiN, Al₂O₃, HfO₂ or TiO₂, a nitride film, or a composite film of these. A thickness of the insulation layer 224 may fall within a range of approximately 10 to 100 nm depending on the gate length.

According to the second embodiment described above, for example, the source electrode 204 and the drain electrode 205 are arranged on the rear side of the substrate 201. Therefore, even if the distance between the source and the drain is set to be shorter, a sufficient distance between the source electrode 205/the source electrode 204 and the gate electrode 203 is ensured, thus the parasitic capacitance generated between the gate electrode 203 and the source electrode 204/the drain electrode 205 is reduced, thereby improving high-frequency characteristics.

### [Third Embodiment]

A semiconductor device according to a third embodiment of the present invention will be described with reference to Figs. 3A and 3B. This semiconductor device includes, for example, two field-effect transistors 100a or 100b, as shown in Fig. 3A. In this example, the field-effect transistors 100b are formed sharing the drain electrode 105 on the rear side of the substrate, and the gate electrodes 103 are connected by a gate wiring 131.

An interlayer insulation layer 301 is formed on the two field-effect transistors 100b, and the gate wiring 131 is formed on the interlayer insulation layer 301. The gate wiring 131 is connected to each gate electrode 103 of the two field-effect transistors 100b by a through-hole via formed through the interlayer insulation layer 301. A source wiring 132a connected to one source electrode 104 of the two field-effect transistors 100b and a source wiring 132b connected to the other source electrode 104 are provided on the interlayer insulation layer 301.

It is also possible to provide two field-effect transistors 100a sharing the source electrode 104 on the rear side of the substrate. In this case, the drain electrode 105 is arranged on the same side as the gate electrode 103, and two drain wirings connected to the respective drain electrodes 105 of the two field-effect transistors 100a are provided on the interlayer insulation layer 301.

When two field-effect transistors are connected sharing the source electrode 104 or the drain electrode on the rear side, the source electrode 104 or the drain electrode can be arranged on the rear side between two gate electrodes 103 on a front side, whereby the degree of freedom in layout is increased in connection and connection distance between the two gate electrodes, and electric resistance and parasitic capacitance can be further reduced.

As shown in Fig. 3B, two field-effect transistors 100a described with reference to Fig. 1A can be provided. In this example, two field-effect transistors 100a are formed sharing the drain electrode 105 on the same front side of the substrate as the gate electrode 103.

An interlayer insulation layer 301 is formed on the two field-effect transistors 100a, and a drain wiring 133 is formed on the interlayer insulation layer 302. The drain wiring 133 is connected to the drain electrode 105 shared by the two field-effect transistors by a through-hole via formed through the interlayer insulation layer 302. A gate wiring 131a connected to one gate electrode 103 of the two field-effect transistors 100a and a gate wiring 131b connected to the other gate electrode 103 are provided on the interlayer insulation layer 302.

It is also possible to provide two field-effect transistors 100b sharing the source electrode 104 on the front side of the substrate. In this case, the source electrode 104 is arranged on the same side as the gate electrode 103, and the gate wirings 131a and 131b each connected to the respective gate electrodes 103 of the two field-effect transistors 100a are provided on the interlayer insulation layer 301.

When the two field-effect transistors are connected sharing the source electrode 104 or the drain electrode 105 on the front side, the connection distance between the two gate electrodes can be reduced.

According to the third embodiment, if the wiring connected to the source electrode 104 or the drain electrode 105 arranged on the rear side is laid out well, the degree of freedom can be greatly improved in circuit design. For example, in a case of a common-source, the source wiring connected to the source electrode 104 on the rear side is grounded, and more stable grounding can be implemented than grounding on the front side. Further, in a drain feeder circuit, the drain wiring connected to the drain electrode 105 on the rear side can be laid around using a wide area on the rear side of the substrate, so that the degree of freedom of layout is increased on the front side, while the current capacity can be made higher by forming the wiring arranged on the rear side to be thicker.

As described above, according to the present invention, at least one of the source electrode and the drain electrode is formed on the side of the substrate of the channel layer, thus the distance between the gate electrode and the source and drain electrodes can be further reduced to speed up the transistor. According to the present invention, the source electrode or the drain electrode in ohmic contact is arranged on the rear side, thus the degree of freedom in layout can be increased in connection and connection distance between the two gate electrodes, and electric resistance and parasitic capacitance can be further reduced.

In either case, since the degree of freedom can be greatly improved in circuit design by the layout of the wiring of the source electrode or the drain electrode arranged on the rear side, the degree of freedom can be increased in layout of the wiring arranged on the front side, while the wiring on the rear side can be formed thicker and the wiring having high current capacity can be formed.

It will be appreciated that the present invention is not limited to the embodiments described above and modifications and combinations can be made by those skilled in the art without departing from the scope of the present invention.

### [Reference Signs List]

- 100a:: Field-effect transistor
- 101:: Substrate
- 102:: Channel layer
- 103:: Gate electrode
- 104:: Source electrode
- 105:: Drain electrode
- 106a:: First carrier supply layer
- 106b:: Second carrier supply layer
- 107a:: First barrier layer
- 107b:: Second barrier layer
- 108a:: First contact layer
- 108b:: Second contact layer
- 109a:: First etching stop layer
- 109b:: Second etching stop layer
- 120:: Opening
- 121:: Recess region
- 123:: Groove
- 124:: Insulation layer

## Claims

1. A semiconductor device comprising:
a field-effect transistor, which includes
a channel layer made of a compound semiconductor and formed on a substrate;
a gate electrode formed on the channel layer; and
a source electrode and a drain electrode, both formed with the gate electrode interposed therebetween,
wherein at least one of the source electrode and the drain electrode is formed on a side of the substrate of the channel layer.

2. The semiconductor device according to claim 1, wherein two of the field-effect transistors are provided on the substrate, the two field-effect transistors sharing the gate electrode, the source electrode on an upper side of the channel layer, or the drain electrode on the upper side of the channel layer.

3. The semiconductor device according to claim 1 or 2, further comprising:
a first carrier supply layer formed between the source electrode and the channel layer;
a first barrier layer made of a compound semiconductor and formed between the source electrode and the channel layer;
a second carrier supply layer formed between the drain electrode and the channel layer; and
a second barrier layer made of a compound semiconductor and formed between the drain electrode and the channel layer.

4. The semiconductor device according to claim 3, wherein the source electrode, the first carrier supply layer, and the first barrier layer are formed on the side of the substrate of the channel layer.

5. The semiconductor device according to claim 3, wherein the drain electrode, the second carrier supply layer, and the second barrier layer are formed on the side of the substrate of the channel layer.

6. The semiconductor device according to claim 5, wherein
the source electrode, the first carrier supply layer, and the first barrier layer are formed on the side of the substrate of the channel layer,
the first carrier supply layer and the second carrier supply layer are integrally formed, and
the first barrier layer and the second barrier layer are integrally formed.

7. The semiconductor device according to claim 6, further comprising:
a third carrier supply layer formed between the channel layer and the gate electrode.

8. The semiconductor device according to any one of claims 3 to 7, further comprising:
a first contact layer made of a compound semiconductor and formed between the source electrode and the first barrier layer; and
a second contact layer made of a compound semiconductor and formed between the drain electrode and the second barrier layer,
wherein the source electrode is formed in ohmic contact with the first contact layer, and
the drain electrode is formed in ohmic contact with the second contact layer.
